Europäisches Patentamt

European Patent Office

Office européen des brevets

(11) Publication number: **0 138 270**
**B1**

(12) EUROPEAN PATENT SPECIFICATION

(45) Date of publication of patent specification: 25.05.88

(51) Int. Cl.⁴: **G 01 N 24/00, H 01 F 7/00**

(21) Application number: 84201432.6

(22) Date of filing: 05.10.84

(54) Nuclear magnetic resonance apparatus.

(30) Priority: 14.10.83 NL 8303533

(43) Date of publication of application:
24.04.85 Bulletin 85/17

(45) Publication of the grant of the patent:
25.05.88 Bulletin 88/21

(84) Designated Contracting States:
CH DE FR GB LI NL

(56) References cited:
DE-A-2 146 071
DE-A-2 951 018
GB-A-1 285 694
US-A-3 495 162
US-A-3 564 398

C.L. PARTAIN et al.: "Nuclear magnetic
resonance imaging", W.B. SAUNDERS, 1983,
section 9;

C.E. ROOS et al.: "Superconducting magnets",
pages 115-127

(73) Proprietor: N.V. Philips' Gloeilampenfabrieken
Groenewoudseweg 1
NL-5621 BA Eindhoven (NL)

(72) Inventor: van Geuns, Johannes Rudolphus
c/o INT. OCTROOIBUREAU B.V. Prof. Holstlaan 6
NL-5656 AA Eindhoven (NL)

(74) Representative: Scheele, Edial François et al
INTERNATIONAAL OCTROOIBUREAU B.V. Prof.
Holstlaan 6
NL-5656 AA Eindhoven (NL)

## Description

The invention relates to a nuclear magnetic resonance (NMR) apparatus which comprises a magnet with a first electromagnetic coil system for generating a homogeneous magnetic field in an examination space within the magnet, and also relates to a magnet for such an apparatus.

Such a nuclear magnetic resonance apparatus in the form of an NMR tomograpy apparatus is known from Computertomographie 1, 1981, pages 2—10. In apparatus of this kind comparatively strong stray fields occur outside the magnet. These stray fields are extensively dealt with in an article in Diagnostic Imaging, April 1983, pp 32—35; it is noted therein that such stray fields do not occur in a magnet system consisting of permanent magnets. The drawbacks of such a magnet system are also mentioned in this article. The drawback of external stray fields is not only that they are so strong, particularly in NMR tomography apparatus, that they are also liable to have a disturbing effect on equipment arranged outside the magnet, but also that the measurement field in the magnet is liable to be disturbed by external variations of the stray field, for example due to the displacement of comparatively large pieces of magnetic material therein. For NMR apparatus comprising superconducting magnet such as used notably for NMR tomography apparatus, it is to be noted that the magnet field, and hence also the stray field, is always present therein. For a more detailed description of superconducting magnets for notably diagnostic NMR tomography apparatus, reference is made to the chapter "Superconductivity" on pp 116—127 of the book "Nuclear Magnetic Resonance Imaging" by C. L. Partain et al, WB Saunders Company, 1983; this process will be referred to hereinafter as NMR imaging. NMR apparatuses provided with a coil system for reducing stray fields are known from documents GB—A—1 285694 and DE—A—2951 018, for example.

It is the object of the invention to provide an NMR apparatus which comprises an electromagnetic coil system for generating a homogeneous magnetic field and in which the external magnetic stray field is reduced. To this end, an NMR apparatus of the kind set forth in accordance with the invention is defined and characterized in claim 1 of the present application.

Because the external magnetic stray field is compensated for in an NMR apparatus in accordance with the invention, the disturbing effects thereof are cancelled. This substantially simplifies the steps and facilities required for the use and installation of the apparatus. Moreover, the possibly detrimental effects on the homogeneity of the magnetic field in the measurement space of known apparatus by external influencing of the stray field is avoided. In comparison with the shielding by means of a shield of magnetic material, a substantial saving is achieved as regards space and weight.

In the embodiment according to claim 1, the apparatus comprises a first coil system having a cross-section $O_1$ and a field strength $H_1$, the second coil system has a cross-section $O_2$ and is adapted to generate a field strength $H_2$ so that $H_1 \times O_1 = -H_2 \times O_2$. Therein, $O_2$ may be equal from example, to approximately from 1.4 to 4 times $O_1$; so in the case of circular coil systems a diameter ratio of the two coils of between approximately 1.2 and 2 is obtained. This construction combines a suitably usable diameter of the entire magnet system with an acceptable spacing of the two coil systems and an acceptable current intensity for notably the inner coil. A particularly attractive construction is obtained when the ratio of the cross-sections of the coils equals 2, because the Lorentz force on the current conductors of the first coil system is then reduced to zero.

In a further preferred embodiment, ends of current conductors of the second coil system are electrically conductively interconnected. Consequently, a magnetic flux generated in the first coil system will induce such a magnetic flux in the second coil system that the previously described condition is satisfied. Similarly, the first coil system may also be short-circuited and, moreover, both coil systems may be interconnected in order to carry a corresponding winding current, thus enhancing the stability of the magnet system.

Notably for NMR tomography apparatus as used for medical diagnosis it is attractive to compose the magnet system from superconducting coil systems. In the case of short-circuits, the electrical connections will also consist of a superconducting material. The desired magnetic flux for the coils can then also be generated by means of a magnetic flux pump. The drawback that the measurement field is reduced by the shield in superconducting magnets can be easily mitigated by increasing the superconducting current through the coils. When the magnet system is suitably constructed, this increase will not be problematic, because the external magnetic field at the area of the current windings in existing apparatus acts as a restrictive factor for the permissible current ( see Nmr imaging, pp. 116—120) and this magnetic field is now completely eliminated or substantially reduced.

In a further preferred embodiment involving superconducting coil systems, the second coil system is formed by a single cylinder or a plurality of cylinders of superconducting material which are concentrically or consecutively arranged and which have comparatively thin walls. The desired magnetic field for the second coil system is then generated by induction from the first coil system in this second coil system. By constructing the second coil system so that, viewed in the axial direction, it is longer than the first coil system, the compensation for the stray field can be further improved. It can be improved even further by providing axial ends of the second coil system with radially directed elements which also consist of a superconducting material when superconducting magnets are used, said elements being shaped, for example as plates, rings or spirals. These elements preferably extend beyond the turns of the first coil system and force the field lines even further towards the space between the two coil systems due to the super-conducting currents to be generated.

When the second coil system acts as a heat shield for the first coil system, it may be advantageous to use a material for the second coil system which has a comparatively high transition point for the superconductivity. This offers an additional protection for the first coil system and a substantial saving as regards the consumption of helium can thus be obtained, for example in the case of external cooling of the second system (see Nmr imaging, p 126). In order to obtain minimum dimensions of the complete magnet system, both coil systems are preferably accommodated in a single Dewar vessel which is to be filled with liquid helium. Because the second coil system is in principle arranged as closely as possible about the first coil system, a comparatively strong reduction of the measurement field will occur. Therefore, the first coil system is preferably made of materials which allow for comparatively high persistent superconducting currents. In a preferred embodiment, gradient coils which are to be included in a magnet system in accordance with the invention in order to generate position-determining gradient fields in the measurement space are constructed so that optimum use is made of the compensation of magnetic fields near the gradient coil windings.

Some preferred embodiments in accordance with the invention will be described in detail hereinafter with reference to the drawing. Therein:

Figure 1 diagrammatically shows an NMR apparatus in accordance with the invention, and

Figure 2 shows various embodiments of a coil system for such an apparatus.

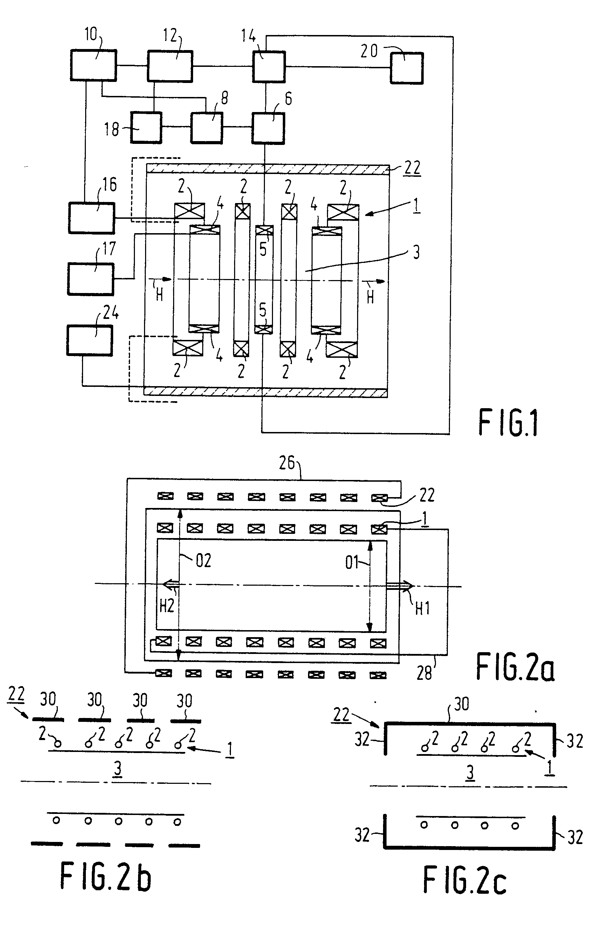

An NMR apparatus as shown in figure 1 comprises a magnet with an electromagnetic coil system 1 which in this case comprises four wire windings 2 for generating a strong, steady, homogeneous magnetic field in a measurement space 3 which is situated inside the coil system. For various feasible coil systems, reference is made to Nmr imaging, pp 121—123. For the use as an NMR tomography apparatus to be described hereinafter, that is to say for the slice-wise imaging of an object, gradient coils 4 are used. NMR spectometry apparatus, that is to say apparatus for the detection of different types of spin nuclei of elements or molecules in an object, do not require gradient coils.

Furthermore, RF coils 5 which act as transmission coils for an RF electromagnetic field and as detection coil for nuclear spin resonance signals which are generated thereby are arranged comparatively closely about the measurement space. Alternatively, separate coils can be used for these two functions. Nuclear spin resonance signals stimulated by the RF electromagnetic field in an object to be measured are picked up via a signal amplifier 6 in order to be applied, *via* a phase-sensitive amplifier 8, to a central arithmetic and control unit 10. Also shown are a modulator 12 for an RF power supply source 14, a power supply source 16 for the main coil system, a power supply source 17 for the gradient coils, a high-frequency oscillator 18 and a monitor 20 for image display. The oscillator 18 controls the modulator 12 for the RF fields as well as the phase sensitive amplifier 8 which processes the measurement signals.

In accordance with the invention, a second magnet coil system 22 is arranged about the first magnet coil system which comprises the windings 2. When resistance coils are used for the first coil system, the second coil system preferably also comprises resistance coils; however, when superconducting magnet coils are used for the first coil system, the second coil system preferably also comprises superconducting coils. The second magnet coil system can be powered by a power supply source 24 which may be a current source as well as a flux pump in the case of superconducting magnets. It is an important aspect that the power supply source is continuously activated in the case of resistance magnets and forms a closed circuit in conjunction with the windings, whilst the source is only active to generate the persistent current in the case of superconducting magnets. By a suitable choice of the geometry and the energizing of the second coil system, which may again be a single solenoid or the like, outside the two magnet coil systems a magnetic field can be generated which compensates for the magnetic stray field of the first coil system which prevails at that area. The strongly disturbing magnetic stray field otherwise occurring at this area is thus cancelled to a high degree, so that it is achieved not only that all very strict measures for the protection of humans and materials outside the magnet can be dispensed with, but also that the measurement field is shielded against disturbances by fluctuations in the stray field. The latter shielding results in a more homogeneous magnetic field in the measurement space and hence in an increased resolution, i.e. spatially in the case of tomography was well as spectrally in the case of spectrometry.

For example, if $O_1 \times H_1 = -O_2 \times H_2$ in a con-struction as shown in figure 2a with a radial cross-sectional area $O_1$ of the first coil system for generating an axial magnetic field $H_3$ and a radial cross-sectional area $O_2$ of the second coil system in which an opposed axial magnetic field $H_2$ is generated, the resultant external magnetic field will be cancelled to a very high degree. If, for example $O_2 = 2 \times O_1$, so in the case of circular coil winding $R_2 = V_2 \times R_1$, $H_1 = -2 \times H_2$. A mag-netic field $H_3$ thus produced in the measurement space will then be equal to $-H_2$ or $\frac{1}{2}H_1$. It now holds good that a magnetic flux enclosed by the first coil system is equal to but oppositely directed with respect to a flux enclosed by the space between the two coil systems. Consequently there is no flux which is enclosed by the coil systems together, so that no magnetic flux remains in the form of a stray field about the coil system. The field strength in the measurement space is reduced to one half of the original value in this construction. This may be considered to be objectionable, but this reduction can be compensated for by increased energizing of the first coil system. For a comparatively small magnet, for example for spectrometry on small objects, this need not be objectionable. For resistance magnets for tomography or spectrometry on patients, in which case the apparatus are comparatively large, this drawback could render the use of the invention problematic. In the case of superconducting coil systems, this drawback is irrelevant from a point of view of energy, consumption or heat dissipation. The presistent currents can be increased to high values. An extremely attractive additional advantage of the invention is that the known limitations as regards the intensity of the persistent currents (see Nmr imaging, pages 116—121) are completely eliminated in the last preferred construction described, because no external magnetic field strength occurs therein at the area of the windings of the first coil system, so that no interference is experienced from Lorentz forces or the quenching etc. described in nmr imaging p. 120.

In this preferred embodiment the current intensity of the persistent current for the first coil system, consequently, is limited only by its critical value with regard to the materials used without an additional magnetic field; this value is many times higher than that for known superconducting magnet systems.

In order to avoid the adverse effects of Lorentz forces also when the magnet systems are energized, both coil systems are preferably simultaneously energized. This can be achieved in the present coil system by electrically shortcircuiting ends of turns of the second coil system *via* a diagrammatically shown connection 26. In the case of superconducting coils, this short-circuit will also consist of superconducting material. When the first coil system is energized via a current source or a flux pump, a current will be induced in the second coil system which generates a magnetic field of an intensity such that the second coil system does not enclose a resultant flux; thus, this is the field strength required for optimum compensation of the stray field. The energizing of the first coil system will be such that the resultant field strength of both systems in the measurement space has the value desired for the measurements. A similar superconducting electric short-circuit 28 can also be used for the first coil system.

Using a suitably adapted geomery of both coil systems, the simultaneous energizing can also be achieved, maintaining the favourable 2:1 ratio of the coil surfaces, by composing both coil systems from continuous current conductors. The current intensity in both coil systems is then always equal, so that an extremely stable system is obtained. A superconducting version of such a system can also be energized by a current source or a flux pump.

In the embodiment shown in figure 2b, the second coil system comprises one or more superconducting cylinders 30 which are concentrically or axially arranged with respect to one another. The risk of disturbing the magnetic field by a short-circuit connection of the second coil system is thus eliminated. In this construction, the second coil system is preferably energized by induction from the first coil system. The first coil system may also consist of such cylinders. When a superconductor having a comparatively high transition temperature is chosen as the material for the cylinder or cylinders of the second coil system, the second coil system can act as a heat shield for the first coil system. The cylinders of the second coil system can then be cooled, for example by an external refrigerator; this may have a favourable effect on the consumption of helium.

Figure 2c shows an embodiment in which the second coil system 22 is longer, viewed in the axial direction, than the first coil system 1; at its ends radially directed annuylar plates 32 are provided. In these plates, which may also be shaped as rings or spirals, circular currents are introduced which will force the magnetic field lines of the first system even further between the two coil systems, so that the external flux will even be better compensated for. In each of the described coil systems auxiliary coils may be included for further homogenizing of the resultant magnetic field. These auxiliary coils are preferably also superconducting and form closed turns so that the desired persistent current can be produced therein by a flux pump or a current source.

Although the 2:1 surface ratio of the two coil systems is extremely favourable, it need not be restricted to this value. Actually, any structurally feasible ratio may be chosen. In a system where one coil system is arranged as closely as possible about the other coil system, a substantial saving of space will be thus achieved, notably also for the helium dewar vessel in the case of superconducting magnets. The resultant magnetic field in the measurement space, however, will then be comparatively small. For a diameter of 0.5 m of the first coil system and 0.6 m of the second coil system, the surface ratio will be approximately 3:4 and the field strength in the measurement space will amount to one quarter of the field strength without compensating coil system. Therefore, the persistent current in the first coil system will have to be increased by a factor 4 in the same circumstances. Because the magnetic field near the turns of the first coil system will not be completely compensated for when this geometry is used, it may be objectionable for some applications. This objection need not exist, for example in the case of comparatively small superconducting systems for spectrometry where a suitable shielding of the coil screen may be extremely desirable, notably for the surrounding equipment. On the other hand, a second coil system having a much larger diameter will only slightly reduce the measurement field. A second coil system having a surface which is 10 times larger than the surface of the first system will reduce the measurement field by only 10%. It is a drawback that because of this large dimension, which itself is already a drawback, the shielding will be less complete. For a superconducting construction of the second coil system this configuration is comparatively unattractive because use must certainly be made of two different cooling systems. In the case of a resistance magnet, this construction may be advantageous because the energy consumption of the first coil system will not be excessively increased. An extreme consequence of the invention is formed by a Halmholtz coil system which is so much larger then the first coil system that the measurement field is hardly reduced at all. These Helmholtz coils may also be made of a superconducting material.

## Claims

1. A nuclear magnetic resonance apparatus comprising a magnet with a first electromagnetic coil system (1) for generating a homogeneous magnetic field (H) in an examination space (3) within the magnet, and a second electromagnetic coil system (22) arranged concentrically about the first electromagnetic coil system for generating a stray field compensating second magnetic field, characterized in that the product of the surface $O_2$ of a radial cross-section of the second coil system and a field strength $H_2$ to be generated thereby is at least substantially equal to the negative value of the corresponding product $O_1 \times H_1$ of the first coil system (1).

2. An NMR apparatus as claimed in Claim 1, characterized in that the ratio of said surfaces ($O_1$, $O_2$) is approximately 1:2.

3. An NMR apparatus as claimed in any one of the preceding Claims, characterized in that ends of current conductors of the second coil system (22) are mutually electrically short-circuited.

4. An NMR apparatus as claimed in Claim 3, characterized in that the coil of the second coil system (22) and a short-circuit (26) between the ends thereof are made of a superconducting material.

5. An NMR apparatus as claimed in any one of the preceding Claims, characterized in that the first coil system (1) is made of a superconducting material.

6. An NMR apparatus as claimed in Claim 5, characterized in that ends of current conductors of the first coil system (1) are interconnected by way of a superconducting short-circuit (28).

7. An NMR apparatus as claimed in any one of the preceding Claims, characterized in that at least one of the coil systems (1, 22) is adapted to be energized by a magnetic flux generator.

8. An NMR apparatus as claimed in Claim 5, 6 or 7, characterized in that the second coil system (22) is composed from a number of mutually radially and/or axially arranged cyclinders (30) of a superconducting material.

9. An NMR apparatus claimed in any one of the Claims 1, 2, 5, 6, 7 or 8, characterized in that the length of the second coil system (22) exceeds that of the first coil system (1).

10. An NMR apparatus as claimed in Claim 9, characterized in that the second coil system (22) is made of a superconducting material and is provided, at least at one of its ends, with elements of a superconducting material which extend radially at least as far as the vicinity of the first coil system.

11. An NMR apparatus as claimed in any one of the preceding Claims, characterized in that the second coil system (22) is made of a material having a superconducting temperature transition point which is comparatively high with respect to the material of the first coil system (1).

12. An NMR apparatus as claimed in Claim 1, characterized in that an external refrigerating machine is included for the cooling of the second coil system (22).

13. An NMR apparatus as claimed in Claim 1 or 2, characterized in that the second coil system (22) is constructed so that it forms a heat shield for the first coil system (1).

14. An NMR apparatus as claimed in any one of the preceding Claims, characterized in that current conductors of the first coil system (1) which are made of a superconducting material are suitable for carrying persistent currents having an intensity in excess of 100 A.

15. An NMR apparatus as claimed in Claim 4, characterized in that the geometry of the current conductors of the first coil system (1) and the geometry of the current conductors of gradient coils included in the magnet are suitable to achieve minimum Lorentz forces from the local magnetic field resulting from the magnetic fields of the two coil systems (1, 22).

16. An NMR apparatus as claimed in any one of the preceding Claims, characterized in that, using super-conducting material for both coil systems (1, 22), the second coil system (22) is arranged as closely as possible about the first coil system (1).

17. An NMR apparatus as claimed in any one of the preceding Claims, characterized in that, using a superconducting material for both coil systems (1, 22), the coils of a said systems (1, 22) are accommodated together in a helium Dewar vessel.

18. An NMR apparatus as claimed in Claim 17, characterized in that, using an adapted cross-section and number of wire turns for the second coil system (22), both coil systems (1, 22) are superconductively connected in series in order to carry the same persistent current.

19. An NMR apparatus as claimed in any one of the preceding Claims, characterized in that auxiliary coils which homogenize the magnetic field are included in the magnet.

20. A magnet system composed of a magnet with first electromagnet coil system (1) for generating a homogeneous magnetic field (H) in an examination space (3) within the magnet, a second electromagnetic coil system (22) arranged concentrically about the first electromagnetic coils system (1) for generating a stray field compensating second magnetic field, characterized in that the product of the surface $O_2$ of a radial cross-section of the second coils system (22) and a field strength $H_2$ to be generated thereby is at least substantially equal to the negative value of the corresponding product $O_1 \times H_1$ of the first coil system (1).

**Patentansprüche**

1. Kernspinresonanzgerät mit einem Magneten mit einem ersten elektromagnetischen Spulensystem (1) zum Erzeugen eines homogenen Magnetfelds (H) in einem Untersuchungraum (3) im Magneten und mit einem zweiten elektromagnetischen Spulensystem (22), das zum Erzeugen eines ein Streufeld kompensierenden zweiten Magnetfelds konzentrisch um das erste elektromagnetische Spulensystem angeordnet ist, hgekennzeichnet, dass das Produkt der Fläche $O_2$ eines radialen Querschnitts durch das zweite Spulensystem und einer dabei zu erzeugenden Fledstärke $H_2$ wenigstens hauptsächlichen gleich dem negativen Wert des entsprechenden Produkts $O_1 \times H_1$ des ersten Spulensystems (1) ist.

2. Kernspinresonanzgerät nach Anspruch 1, dadurch gekennzeichnet, dass das Verhältnis der genannten Flächen $(O_1, O_2)$ ungefähr 1:2 ist.

3. Kernspinresonanzgerät nach einem der vorangehenden Ansprüche, dadruch gekennzeichnet, dass Enden von Stromleitern des zweiten Spulensystem (22) gegenseitig elektrisch kurzgeschlossen sind.

4. Kernspinresonanzgerät nach Anspruch 3, dadurch gekennzeichnet, dass die Spule des zweiten Spulensystems (22) und eine Kurzschluss (26) zwischen seinen Enden aus einem supraleitenden Material hergestellt sind.

5. Kernspinresonanzgerät nach einem oder mehreren der vorangehenden Ansprüche, dadurch gekennzeichnet, dass das erste Spulensystem (1) aus einem supraleitenden Material hergestellt ist.

6. Kernspinresonanzgerät nach Anspruch 5, dadurch gekennzeichnet, dass Enden von Stromleitern des ersten Spulensystems (1) mittels eines supraleitenden Kurzschluss (28) miteindander verbunden sind.

7. Kernspinresonanzgerät nach einem oder meheren der vorangehenden Ansprüche, dadurch gekennzeichnet, dass wenigstens eines der Spulensystem (1, 22) zum Erregen durch einen Magnetfluxgenerator ausgelegt ist.

8. Kernspinresonanzgerät nach Anspruch 5, 6 oder 7, dadurch gekennzeichnet, dass das zweite Spulensystem (22) aus einer Anzahl gegenseitig radial und/oder axial angeordneter Zylindern (30) aus einem supraleitenden Material besteht.

9. Kernspinresonanzgerät nach einem oder mehreren der Ansprüche, 1, 2, 5, 6, 7 oder 8, dadurch gekennzeichnet, dass die Länge des zweiten Spulensystems (22) die Länge des ersten Spulensystems (1) Überschreitet.

10. Kernspinresonanzgerät nach Anspruch 9, dadurch gekennzeichnet, dass das zweite Spulensystem (22) aus einem supraleitenden Material hergestellt ist und wenigstens an einem seiner Enden mit Elementen aus einem supraleitenden Material ausgerüstet ist, die, sofern sie sich in der Nähe des ersten Spulensystems erstrecken, sich wenigstens radial erstrecken.

11. Kernspinresonanzgerät nach einem oder mehreren der vorangehenden Ansprüche, dadurch gekennzeichnet, dass das zweite Spulensystem (22) aus einem Material mit einem supraleitenden Temperaturübergangspunkt hergestellt ist, der im Vergleich zum Material des ersten Spulensystems (1) hock ist.

12. Kernspinresonanzgerät nach Anspruch 11, dadurch gekennzeichnet, dass eine externe Kühlmaschine zum Kühlen des zweiten Spulensystems (22) aufgenommen ist.

13. Kernspinresonanzgerät nach Anspruch 11 oder 12, dadurch gekennzeichnet, dass das zweite Spulensystem (22) derart aufgebaut ist, dass, es ein Wärmeschutzschirm für das erste Spulensystem (1) bildet.

14. Kernspinresonanzgerät nach einem oder mehreren der vorangehenden Ansprüche, dadurch gekennzeichnet, dass Stromleiter des ersten Spulensystems (1), die aus einem supraleitenden Material hergestellt sind, sich zum Führen von Dauerströmen mit einem Intensität höher als 100 A eignen.

15. Kernsprinresonanzgerät nach Anspruch 14, dadurch gekennzeichnet, dass die Geometrie der Stromleiter des ersten Spulensystems (1) und die Geometrie der Stromleiter von Gradientenspulen im Magneten sich zum Erreichen minimaler Lorentzkräfte aus dem örtlichen Magnetfeld eignen, das aus den Magnetfeldern der beiden Spulensystemen (1, 22) entsteht.

16. Kernspinresonanzgerät nach einem oder mehreren der vorangehenden Ansprüche, dadurch gekennzeichnet, dass unter Verwendung von supraleitendem Material für beide Spulensystem (1, 22) das zweite Spulensystem (22) möglichst nahe beim ersten Spulensystem (1) angeordnet wird.

17. Kernspinresonanzgerät nach einem oder mehreren der vorangehenden Ansprüche, dadurch gekennzeichnet, dass unter Verwendung eines supraleitenden Materials für beide Spulensysteme (1, 22) die Spulen dieser Systeme (1, 22) zusammen in einem Helium-Dewar-Gefäss angeordnet sind.

18. Kernspinresonanzgerät nach Anspruch 17, dadurch gekennzeichnet, dass unter Verwendung eines angeglichenen Querschnitts und einer Anzahl von Drahtwindungen für das zweite Spulensystem (22) beide Spulensysteme (1, 22) supraleitend reihengeschaltet sind, um den gleichen Dauerstrom führen zu können.

19. Kernspinresonanzgerät nach einem oder mehreren der vorangehenden Ansprüche, dadurch gekennzeichnet, dass Hilfsspulen, die das Magnetfeld homogenisieren, in den Magneten aufgenommen sind.

20. Magnetsystem, bestehend aus einem Magneten mit einem ersten elektromagnetischen Spulensystem (1) zum Erzeugen eines homogenen Magnetfelds (H) in einem Untersuchungsraum (3) im Magneten, mit einem zweiten elektromagnetischen Spulensystem (22), das zum Erzeugen eines ein Streufeld kompensierenden zweiten Magnetfelds um das erste elektromagnetische Spulensystem (1) konzentrisch angeordnet ist, dadurch gekennzeichnet, dass das Produkt der Fläche $O_2$ eines radialen Querschnitts des zweiten Spulensystems (22) und einer dabei zu erseugenden Feldstärke $H_2$ wenigstens hauptsächlich gleich dem negativen Wert des entsprechenden Produkts $O_1 \times H_1$ des ersteb Spulensystem (1) ist.

## Revendications

1. Appareil de résonance magnétique nucléaire comprenant un aimant comportant un premier système de bobine électromagnétique (1) pour produire un champ magnétique homogène (H) dans un espace d'examen (3) à l'intérieur de l'aimant, et un second système de bobine électromagnétique (2) disposé concentriquement autour du premier système de bobine électromagnétique pour engendrer un second champ magnétique compensant le champ de dispersion, caractérisé en ce que le produit de la surface $O_2$ d'une section transversale radiale du second système de bobine et d'une intensité de champ $H_2$ à produire ainsi est au moins en substances et la géométrie des conducteurs de courant des bobines $O_1 \times H_1$ du premier système de bobine (1).

2. Appareil de RMN suivant la revendication 1, caractérisé en ce que le rapport des dites surfaces $O_1$, $O_2$ est d'environ 1:2.

3. Appareil de RMN suivant l'une quelconque des revendications précédentes, caractérisé en ce que les extrémités de conducteurs de courant du second système de bobine (22) sont mutuellement courtcircuitées électriquement.

4. Appareil de RMN suivant la revendication 3, caractérisé en ce que la bobine du second système de bobine (22) et un court-circuit (26) entre ses extrémités sont faits d'une matière supraconductrice.

5. Appareil de RMN suivant l'une quelconque des revendications précédentes, caractérisé en ce que le permier système de bobine (1) est fait d'une matière supraconductrice.

6. Appareil de RMN suivant la revendication 5, caractérisé en ce que les extrémités de conducteurs de courant du premier système de bobine (1) sont interconnectées par un court-circuit supraconducteur (28).

7. Appareil de RMN suivant l'une quelconque des revendications précédentes, caractérisé en ce qu'au moins un des systèmes de bobines (1, 22) peut être excité par un générateur de flux magnétique.

8. Appareil de RMN suivant la revendication 5, 6 ou 7, caractérisé en ce que la second système de bobine (22) est formé d'un certain nombre de cylindres (30) en une matière supraconductrice, disposés radialement et/ou axialement les uns par rapport aux autres.

9. Appareil de RMN suivant l'une quelconque des revendications 1, 2, 5, 6, 7 ou 8, caractérisé en ce que la longuer de second système de bobine (22) excède celle du premier système de bobine (1).

10. Appareil de RMN suivant la revendication 9, caractérisé en ce que le second système de bobine (22) est fait d'une matière supraconductrice et est pourvu, au moins à une de ses extrémités, d'éléments en une matière supraconductrice qui s'étandent radialement au moins jusqu'au voisinage du premier système de bobine.

11. Appareil de RMN suivant l'une quelconque des revendications précédentes, caractérisé en ce que le second système de bobine (22) est fait d'une matière présentant un point de transition de température de supraconduction qui est relativement eleveé par rapport à celui de la matière du premier systéme de bobine (1).

12. Appareil de RMN suivant la revendication 11, caractérisé en ce qu'un machine frigorifique externe est prévue pour le refroidissement du second système de bobine (22).

13. Appareil de RMN suivant la revendication 11 ou 12, caractérisé en ce que le second système de bobine (22) est construit de manière à former un blindage thermique pour le premier système de bobine (1).

14. Appareil de RMN suivant l'une quelconque des revendications précédentes, caractérisé en ce que des conducteurs de courant du premier système de bobine (1), qui sont faits d'une matière supraconductrice, sont à même de supporter des courants persistants d'une intensité supérieure à 100 A.

15. Appareil de RMN suivant la revendication 14, caractérisé en ce que la géométrie des conducteurs de courant du premier système de bobine (1) et la géométrie des conducteurs de courant des bobines de gradient incluses dans l'aimant sont adéquates pour donner des forces de Lorentz minimales à partir du champ magnétique local résultant des champs magnétiques des deux systèmes de bobines (1, 22).

16. Appareil de RMN suivant l'une quelconque des revendications précédentes, caractérisé en ce que, lorsqu'une matière supraconductrice est utilisée pour les deux systèmes de bobines (1, 22), le second système de bobine (22) est disposé aussi étroitement que possible autour du premier système de bobine (1).

17. Appareil de RMN suivant l'une quelconque des revendications précédentes, caractérisé en ce que, lorsqu'une matière supraconductrice est utilisée pour les deux systèmes de bobines (1, 22), les bobines des systèmes (1, 22) sont logées ensemble dans un vase de Dewar à hélium.

18. Appareil de RMN suivant la revendication 17, caractérisé en ce que, lorsqu'une section transversale et un nombre de spires adaptés sont utilisés pour le second système de bobine (22), les deux systèmes de bobines (1, 22) sont connectés de manière supraconductrice en série pour qu'ils supportent le même courant persistant.

19. Appareil de RMN suivant l'une quelconque des revendications précédentes, caractérisé en ce que des enroulements auxiliaires, qui rendent le champ magnétique homogène, sont inclus dans l'aimant.

20. Système magnétique composé d'un aimant comportant un permier système de bobine électromagnétique (1) destiné à engendrer un champ magnétique homogène (H) dans un espace d'examen (3) à l'intérieur de l'aimant, un second système de bobine électromagnétique (22) disposé concentriquement autour du premier système de bobine électromagnétique (1) pour engendrer un second champ magnétique compensant le champ de dispersion, caractérisé en ce que le produit de la surface $O_2$ d'une section transversale radiale du second système de bobine (22) et d'une intensité de champ $H_2$ à engendrer ainsi, est au moins en substance égal à la valeur négative du produit correspondant $O_1 \times H_1$ du premier système de bobine (1).

FIG.1

FIG.2a

FIG.2b

FIG.2c